Europäisches Patentamt

European Patent Office

Office européen des brevets

(19)

(11) **EP 0 964 256 A1**

(12) **DEMANDE DE BREVET EUROPEEN**

(43) Date de publication:
**15.12.1999 Bulletin 1999/50**

(51) Int Cl.$^6$: **G01R 31/08**

(21) Numéro de dépôt: **99401392.8**

(22) Date de dépôt: **10.06.1999**

| | |
|---|---|
| (84) Etats contractants désignés:<br>**AT BE CH CY DE DK ES FI FR GB GR IE IT LI LU MC NL PT SE**<br>Etats d'extension désignés:<br>**AL LT LV MK RO SI** | • **AUTOMOBILES CITROEN**<br>**92200 Neuilly-sur-Seine (FR)** |
| (30) Priorité: **10.06.1998 FR 9807282** | (72) Inventeur: **Isler, Serge**<br>**25600 Nommay (FR)** |
| (71) Demandeurs:<br>• **AUTOMOBILES PEUGEOT**<br>**75116 Paris (FR)** | (74) Mandataire: **Gendraud, Pierre et al**<br>**GIE PSA - Peugeot - Citroen,**<br>**Département Propriété Industrielle,**<br>**18, Rue des Fauvelles**<br>**92250 La Garenne Colombes (FR)** |

(54) **Procédé et dispositif de localisation des courts-circuits dans un bus d'un réseau de transmission d'informations multiplexé**

(57)     Le réseau comportant une pluralité de calculateurs ou stations reliées à une unité centrale via au moins un bus, le ou les bus étant constitués d'une pluralité de fils conducteurs, caractérisé en ce que le procédé comporte:

-   deux étapes (101,102) de mesure de la résistance ohmique du bus réalisée respectivement sensiblement au niveau des deux extrémités du bus,

-   une étape (103) de calcul de la distance du court-circuit par rapport à une des extrémités du bus en fonction des valeurs connues de résistivité et de résistance totale du bus, et

-   une étape (104) de comparaison de la distance calculée du court-circuit par rapport à une des extrémités du bus avec les longueurs connues des bus ainsi que les emplacements relatifs connus des calculateurs ou stations du réseau.

FIG.2

## Description

L'invention se rapporte à un procédé de localisation des courts-circuits dans au moins un bus d'un réseau de transmission d'informations multiplexé ainsi qu'à un dispositif de diagnostic d'un tel réseau mettant en oeuvre le procédé.

L'invention peut s'appliquer, par exemple, au diagnostic du réseau électronique de transmission d'informations multiplexé de véhicules, notamment automobiles.

La détection de dysfonctionnements dans le réseau électronique multiplexé de certains véhicules est effectuée par la connexion au réseau d'un dispositif de diagnostic. Les différents calculateurs munis d'une ligne de diagnostic délivrent des informations au dispositif de diagnostic sur les pannes ou dysfonctionnement des organes raccordés au réseau. Au cours de la vie d'un véhicule, les nombreux faisceaux de fils constituant le réseau électrique du véhicule peuvent se détériorer à divers endroits en raison, par exemple, de frottements contre la structure du véhicule.

Lorsqu'un fil des bus du réseau est coupé, les calculateurs situés en aval la coupure restent muets vis-à-vis de l'outil de diagnostic. Ceci permet au réparateur de localiser assez facilement l'endroit de la coupure.

Cependant, lorsque les fils du réseau sont en court-circuit entre eux ou contre la structure du véhicule, les codes défauts émis par les calculateurs du réseau vers le dispositif de diagnostic sont insuffisants pour orienter le dépanneur vers l'endroit précis où est situé le court-circuit. Le dépanneur doit donc dans ce cas démonter une grande partie du véhicule pour trouver l'endroit où le ou les fils du bus sont dégradés. Ceci génère un travail long et fastidieux au dépanneur.

Un but de la présente invention est de proposer un procédé de localisation des courts-circuits dans au moins un bus d'un réseau de transmission d'informations multiplexé palliant tout ou partie des inconvénients de l'art antérieur relevés ci-dessus.

Ce but est atteint par le fait que dans le procédé de localisation des courts-circuits dans au moins un bus d'un réseau de transmission d'informations multiplexé, le réseau comporte une pluralité de calculateurs ou stations reliées à une unité centrale via au moins un bus, le ou les bus étant constitués d'au moins deux fils conducteurs; le procédé comportant :

- deux étapes de mesure de la résistance ohmique du bus réalisée respectivement sensiblement au niveau des deux extrémités du bus,

- une étape de calcul de la distance du court-circuit par rapport à une des extrémités du bus en fonction des valeurs connues de résistivité et de résistance totale du bus,

- une étape de comparaison de la distance calculée du court-circuit par rapport à une des extrémités du bus avec les longueurs connues des bus ainsi que les emplacements relatifs connus des calculateurs ou stations du réseau.

Selon une autre particularité chacune des étapes de mesure de la résistance ohmique du bus consiste à mesurer successivement les résistances d'une pluralité de boucles formées chacune par deux fils du bus.

Selon une autre particularité le bus est constitué de deux fils véhiculant l'information, chacune des étapes de mesure de la résistance ohmique du bus consistant à mesurer successivement les résistances des boucles formées par la paire de fils véhiculant l'information et chaque fil véhiculant l'information par rapport aux deux polarités de l'alimentation du véhicule.

Selon une autre particularité les étapes de mesure de la résistance ohmique du bus sont réalisées sur la ligne dite principale du bus qui est connectée à l'unité centrale.

Selon une autre particularité l'étape de calcul de la distance du court-circuit par rapport à une première des extrémités du bus est obtenue par la formule :

$$D1 = \frac{1}{2\rho} \; x \; (R_{BG} - \frac{R_{BG} + R_{BD} - R_T}{2});$$

dans laquelle $R_{BG}$ est la résistance mesurée à la première extrémité du bus, $R_{BD}$ est la résistance mesurée à la seconde extrémité du bus et $R_T$ la résistance totale du bus.

Selon une autre particularité chacune des étapes de mesure de la résistance ohmique du bus comporte une pluralité de mesures de résistance successives pour chaque paire de fils.

Un autre but de l'invention est de proposer un dispositif de diagnostic d'un réseau électronique de transmission d'informations multiplexé mettant en oeuvre le procédé.

Ce but est atteint par le fait que le dispositif de diagnostic d'un réseau électronique de transmission d'informations multiplexé mettant en oeuvre le procédé comporte des moyens de mesure de la résistance ohmique des fils constituant les bus, des moyens de stockage et de traitement de données et des moyens d'affichage interactifs des informations relatives à la localisation du ou des courts-circuits dans le ou les bus du réseau.

Selon une autre particularité les moyens de stockage et de traitement de données coopèrent avec les moyens d'affichage pour indiquer à l'utilisateur l'emplacement de l'une au moins des deux extrémités du bus auxquelles une mesure de résistance doit être effectuée.

Selon une autre particularité les moyens de mesure de la résistance ohmique des fils constituant les bus comportent des moyens de génération d'un courant électrique reliés en parallèle à des moyens de mesure d'une tension de façon à constituer deux bornes de mesure à connecter sur respectivement deux fils du bus.

D'autres caractéristiques et avantages de l'invention apparaîtront à la lecture de la description détaillée qui va suivre, pour la compréhension de laquelle on se reportera aux dessins annexés, dans lesquels :

- la figure 1 représente partiellement et de manière simplifiée le schéma général d'un premier exemple de réseau de transmission d'informations multiplexé,

- la figure 2 représente le schéma équivalent de deux fils d'un bus du réseau de la figure 1,

- la figure 3 représente partiellement et de manière schématique un second exemple de schéma électrique d'un réseau de transmission d'informations multiplexé,

- la figure 4 représente une partie du schéma électrique de la figure 3,

- la figure 5 représente un logigramme du procédé de localisation des courts-circuits dans un bus d'un réseau multiplexé selon l'invention,

- la figure 6 représente schématiquement une partie d'un dispositif de diagnostic d'un réseau mettant en oeuvre le procédé selon l'invention.

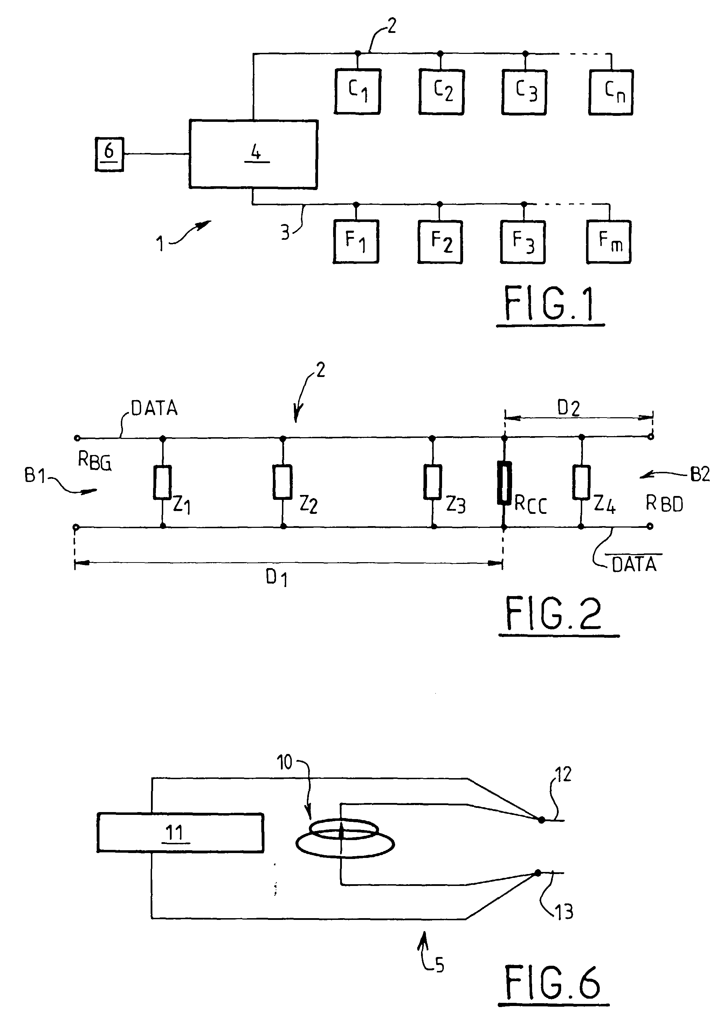

L'invention va à présent être décrite en référence aux figures 1 à 6.

L'invention concerne la localisation des courts-circuits dans le ou les bus d'un réseau de transmission d'informations multiplexé.

La figure 1 représente schématiquement un exemple d'un tel réseau 1 de transmission d'informations multiplexé. Ce réseau 1 comporte deux séries de calculateurs ou stations C1 à Cn et F1 à Fm, qui sont reliées à une unité centrale 4 au moyen respectivement de deux bus 2, 3. Une prise de diagnostic 6 est reliée à l'unité centrale 4.

De manière connue, chaque bus 2, 3 peut être constitué de deux fils véhiculant l'information appelés respectivement DATA et $\overline{\text{DATA}}$. Chaque bus peut éventuellement comporter en outre deux fils d'alimentation appelés de manière classique respectivement PLUS et MASSE. Par soucis de simplification, les deux fils d'alimentation ne seront pas représentés aux figures décrites ci-après.

Selon l'invention, pour localiser un court-circuit dans un bus 2, 3, on mesure successivement la résistance ohmique du bus 2, 3 au niveau sensiblement des deux extrémités de ce bus 2, 3. Ensuite, et comme décrit plus en détail ci-après, on calcule la distance du court-circuit par rapport à une des extrémités du bus 2, 3 en fonction des résistances mesurées aux extrémités du bus et des valeurs connues de résistivité p et de résistance RT totale des fils du bus 2, 3.

Connaissant d'une part la distance du court-circuit par rapport à une des extrémités du bus 2, 3 et d'autre part les emplacements relatifs des calculateurs ou stations C1 à Cn; F1 à Fm du réseau 1, il est alors possible de localiser le court-circuit dans le réseau 1.

La figure 2 représente le schéma équivalent de deux fils DATA, $\overline{\text{DATA}}$, d'un bus 2 du réseau de la figure 1. Quatre stations ayant des impédances respectives Z1, Z2, Z3, Z4 sont connectées entre les deux fils DATA et $\overline{\text{DATA}}$.

Deux types de court-circuit peuvent se produire entre les deux fils DATA et $\overline{\text{DATA}}$. Un premier type de court-circuit est dit "franc" ou "total" c'est-à-dire que les deux fils DATA et $\overline{\text{DATA}}$, sont reliés par une connexion ayant une résistance de court-circuit $R_{CC}$ nulle ou négligeable. Le second type de court-circuit est dit "non-franc" ou "partiel", c'est-à-dire que la résistance de court-circuit $R_{CC}$ est non négligeable.

Pour déterminer la distance D1 d'un court-circuit "partiel" par rapport à une des extrémités B1, 82 du bus 2 selon l'invention, on commence par mesurer les résistances $R_{BG}$ et $R_{BD}$ à la première B1 et à la seconde B2 extrémité de la boucle constituée par les deux fils DATA, $\overline{\text{DATA}}$.

On désigne par $R_T$ la résistance totale de la boucle constituée par les deux fils DATA et $\overline{\text{DATA}}$. Cette résistance totale $R_T$ est supposée connue. On appelle $\rho$ la résistivité connue des fils DATA et $\overline{\text{DATA}}$ du bus 2.

On baptise $R_{BGR}$ et $R_{BDR}$ les résistances mesurées respectivement au niveau des première B1 et seconde B2 extrémités de la boucle constituée par les deux fils, en faisant l'hypothèse dans les deux cas que la résistance de court-circuit $R_{CC}$ est nulle.

D'après la loi d'Ohm, on a les relations suivantes :

$$R_T = R_{BGR} + R_{BDR}$$

$$R_{BG} = R_{BGR} + R_{CC}$$

et

$$R_{BD} = R_{BDR} + R_{CC}$$

A partir des deux dernières égalités, en exprimant la résistance de court-circuit $R_{cc}$ en fonction des autres résistances connues ou mesurées, on obtient :

$$R_{BGR} = R_{BG} - \frac{R_{BG} + R_{BD} - R_T}{2}.$$

$R_{BGR}$ permet de calculer la distance D1 du court-circuit par rapport à la première extrémité B1 du bus. En effet, on a:

$$D1 = \frac{1}{2\rho} \times R_{BGR} = \frac{1}{2\rho} \times (R_{BG} - \frac{R_{BG} + R_{BD} - R_T}{2})$$

Bien entendu, le même raisonnement permettrait d'exprimer la distance D2 du court-circuit par rapport à la seconde extrémité B2 du bus 2.

Pour déterminer la distance D1 d'un court-circuit "total" par rapport à une des extrémités B1, B2 du bus 2 selon l'invention, la formule ci-dessus reste valable puisque dans ce cas $R_{BGR} = R_{BG}$. Cependant, on conçoit aisément que, pour déterminer la distance d'un court-circuit "total" par rapport à une des extrémités du bus, une simple mesure de résistance à une extrémité de la boucle pourrait suffire.

Dans les deux cas (court-circuit "total" ou "partiel"), on constate que la présence des stations connectées entre les deux fils DATA et $\overline{DATA}$, n'entraîne pas de perturbation significative des mesures. En effet, les stations du réseau ont communément des impédances Z1, Z2, Z3, Z4 de l'ordre de 8kΩ qui n'entraînent que des perturbations de mesures négligeables.

Un bus étant constitué classiquement de plusieurs fils, pour localiser un court-circuit dans ce bus selon l'invention, on commence par mesurer la résistance ohmique aux deux extrémités d'une pluralité de boucles formées chacune par deux fils du bus.

Dans le cas d'un bus constitué de deux fils véhiculant l'information DATA et $\overline{DATA}$ et de deux fils d'alimentation PLUS et MASSE, on mesure la résistance aux deux extrémités pour les quatre paires de fils comportant un fil véhiculant l'information et un fil d'alimentation DATA, PLUS; DATA, MASSE; $\overline{DATA}$, PLUS, $\overline{DATA}$, MASSE ainsi que pour la paire de fils DATA, $\overline{DATA}$ véhiculant l'information.

Les valeurs mesurées puis l'application de la formule ci-dessus permettent de déterminer la distance D1 ou D2 d'un court-circuit par rapport à une des extrémités B1, B2 du bus 2.

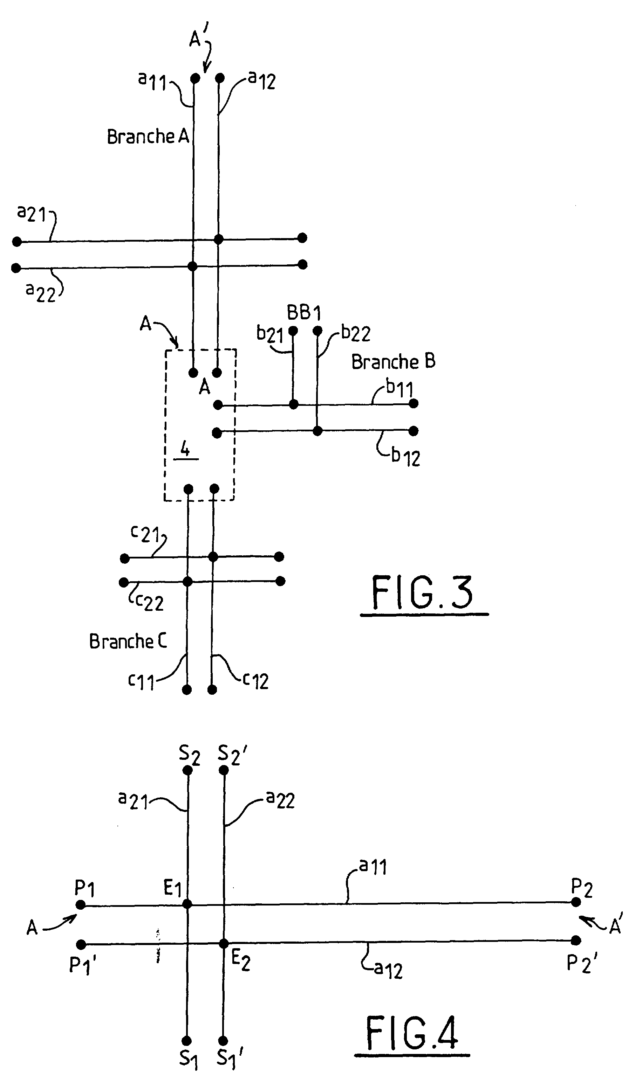

La figure 3 représente un exemple d'un réseau de transmission d'informations multiplexé. Ce réseau ou faisceau comporte trois branches A, B, C. Chacune des branches A, B, C est constituée d'un bus ou ligne principale schématisée par une paire de fils respectivement a11, a12; b11, b12; c11, c12. Une des extrémités de chacune des lignes principales est reliée à l'unité centrale 4.

Trois lignes secondaires a21, a22; b21, b22; c21, c22 sont reliées respectivement aux trois lignes principales a11, a12; b11, b12; c11, c12.

Un exemple de fonctionnement de l'invention pour la branche A représentée à la figure 4 va à présent être décrit plus en détail. Par soucis de simplification, chaque bus ou ligne est schématisée uniquement par deux fils a11, a12; a21, a22.

On appelle L1 = P1P2 = P1'P2' la longueur des fils a11, a12 de la ligne principale. On appelle L2 = S1S2 = S1'S2' la longueur des fils a21, a22 de la ligne secondaire.

Un premier fil a21 de la ligne secondaire est relié en E1 au premier fil a11 de la ligne principale. Le second a22 fil de la ligne secondaire est relié en E2 au second a12 fil de la ligne principale.

On appelle L3 = P1E1 la distance entre la première extrémité A de la ligne principale A et sa liaison E1 avec le premier fil a21 de la ligne secondaire.

On appelle L4 = P1'E2 la distance entre la première extrémité de la ligne principale A et sa liaison E2 avec le second a22 fil de la ligne secondaire.

On appelle L5 = S2E1 et L6 = S2'E2 les distances entre une des extrémités des fils a21, a22 de la ligne secondaire et leur liaison respective E1, E2 avec les fils a11, a12 de la ligne principale.

Les valeurs des longueurs L1, L2, L3, L4, L5 et L6 sont connues par une modélisation prédéfinie du réseau multiplexé.

Supposons la présence d'un court-circuit à l'extrémité S2S2' de la ligne secondaire.

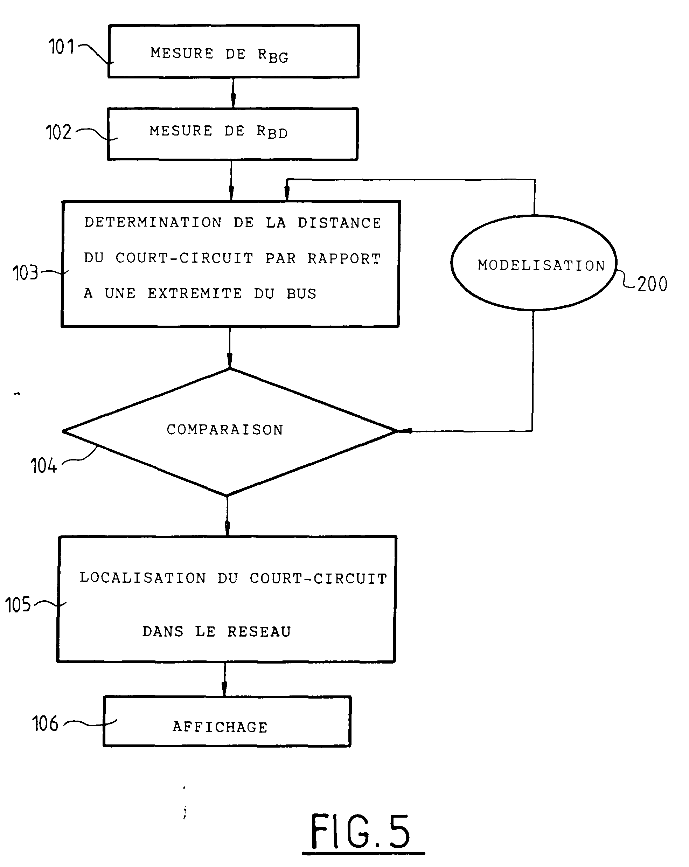

En se référant à la figure 5, on commence selon l'invention par une étape 101 de mesure de la résistance $R_{BG}$ à une première extrémité A de la ligne principale a11, a12 du bus. L'étape suivante 102 est la mesure de la résistance $R_{BD}$ à la seconde extrémité A' de cette ligne principale.

Connaissant la résistance totale $R_T$ de la boucle principale et la résistivité ρ des fils du bus, on détermine à l'étape suivante 103 la distance D1 (ou D2) du court-circuit par rapport à l'une A (ou l'autre A') des extrémités de la ligne principale a11, a12. La distance D1 ou D2 est calculée au moyen de la formule générale donnée ci-dessus.

Les valeurs de la résistance totale $R_T$ de la boucle principale et la résistivité ρ de ses fils sont données par la modélisation 200 prédéfinie du réseau 1.

Dans notre exemple la valeur D1 calculée sera proche des distances connues L3 = P1E1 et L4 = P1'E1'. Dès lors, la distance D1 du court-circuit par rapport à l'une A des extrémités de la ligne principale a11, a12 peut être comparée (étape 104) aux distances L1 à L6 données par la modélisation 200 du réseau.

Dans notre exemple, cette comparaison permettra de conclure (étape 105) que le court-circuit se situe aux environs de l'extrémité S2S2' de la ligne secondaire.

Ainsi, grâce à cette localisation de la dégradation physique du bus du réseau, le dépanneur n'aura donc qu'à rechercher l'anomalie dans une zone bien précise.

Les étapes 101, 102 de mesure de résistance aux extrémités du bus sont réalisée de préférence sur la ligne principale a11, a12; b11, b12, c11, c12 de la branche concerné.

L'invention permet donc de localiser précisément un court-circuit "partiel" ou "total" sur la ligne principale a12, a22 d'un bus ou un court-circuit "total" sur une sous-branche a21, a22 de cette ligne principale. Pour les courts-circuits "partiels" sur une ligne secondaire a21, a22, on a constaté que l'invention permet de déterminer la ligne secondaire sur laquelle se trouve l'anomalie mais pas à coup sûr sa position précise sur cette ligne secondaire. Cependant, cette localisation de la ligne secondaire détériorée constitue une information suffisante pour un dépanneur.

La fonction de localisation des courts-circuits dans les bus d'un réseau 1 selon l'invention peut être intégrée à un dispositif connu de diagnostic du réseau 1. A cet effet, le dispositif de diagnostic comportera en plus des fonctionnalité habituelles, des moyens 5 de mesure de la résistance ohmique des fils constituant les bus 2, 3 ainsi que des moyens de stockage et de traitement de données. Ces moyens de stockage et de traitement de données contiendront notamment la modélisation d'au moins un type de réseau à diagnostiquer.

Le dispositif de diagnostic peut comporter également des moyens (non représentés) d'affichage interactifs des informations relatives à la localisation des courts-circuits dans le ou les bus 2, 3 du réseau 1.

Ce dispositif de diagnostic sera donc apte à effectuer la succession d'étape 101 à 105 décrites ci-dessus en référence à la figure 5. Par ailleurs, une étape supplémentaire 106 peut consister à afficher le résultat de la localisation du ou des courts-circuits.

Comme représenté à la figure 6, les moyens de mesure de la résistance des fils du dispositif de diagnostic peuvent être constitués de moyens 10 de génération d'un courant électrique qui sont reliés en parallèle à des moyens 11 de mesure d'une tension de façon à constituer deux bornes 12, 13 de mesure à connecter respectivement sur deux fils du bus.

Pour être apte à mesurer des courts-circuits "partiels" dont la résistance, de court-circuit est comprise entre 0 et $2\Omega$ dans un réseau dans lequel les fils ont une résistivité de l'ordre de $0,035\Omega$/m et ayant une longueur maximale de l'ordre de 10m, on peut utiliser un générateur 10 de courant constant d'une valeur de 100mA. Les moyens 11 de mesure de tension peuvent quant à eux être constitués d'un millivoltmètre numérique.

Un exemple non limitatif d'utilisation d'un tel dispositif de diagnostic appliqué à un véhicule automobile va à présent être décrit.

Dans un premier temps, le dispositif de diagnostic, qui est raccordé à la prise de diagnostic 6 du véhicule, est utilisé de façon connue pour indiquer le ou les bus 2, 3 du réseau 1 qui présentent une anomalie (figure 1). Lorsqu'un bus présentant une anomalie est détecté, le dépanneur connecte successivement les bornes 12, 13 de mesure de résistance du dispositif de diagnostic aux deux extrémités du bus concerné.

De préférence, les deux extrémités du bus où l'on effectue la mesure de résistance sont situées d'une part au niveau de la connexion du bus 2, 3 à l'unité centrale 4, et d'autre part au niveau de la connexion de ce bus au calculateur le plus éloigné de l'unité centrale 4.

Avantageusement, le dispositif de diagnostic peut indiquer au dépanneur, via les moyens d'affichage, l'identité et l'emplacement du calculateur qui est le plus éloigné de l'unité centrale 4.

Par ailleurs, chacune des étapes 101, 102 de mesure de résistance à une extrémité du bus peut comporter une pluralité de mesures successives réalisées automatiquement. C'est-à-dire que l'on mesure plusieurs fois de suite la résistance aux deux extrémités de chacune des cinq paires de fils DATA, PLUS; DATA, MASSE; $\overline{\text{DATA}}$, PLUS; $\overline{\text{DATA}}$, MASSE et DATA, $\overline{\text{DATA}}$. Le nombre de mesures successives à chaque extrémité peut, par exemple, être égal à cinq.

Lorsque les mesures de résistance ont été effectuées aux deux extrémités du bus concerné, le dispositif de diagnostic effectue automatiquement le traitement des informations mesurées et indique au dépanneur la localisation de court-circuit dans le réseau.

L'opérateur peut alors démonter la partie concernée du véhicule pour remplacer le ou les fils endommagés.

Avantageusement, les moyens de stockage et de traitement de données du dispositif de diagnostic peuvent contenir les modélisations des réseaux multiplexés de plusieurs types de véhicules. C'est-à-dire que chaque modélisation d'un réseau contiendra une cartographie précise du réseau ainsi que les valeurs des grandeurs physiques nécessaires à l'étape de calcul (résistivité des fils et résistance totale de ces derniers).

Les valeurs de résistivité et de résistance totale des fils des bus ainsi que leur longueur seront mesurées une seule fois sur un réseau d'un véhicule étalon avant leur mémorisation dans le dispositif de diagnostic.

On conçoit donc que l'on a selon l'invention un procédé et un dispositif de localisation des courts-circuits au niveau des bus 2, 3 d'un réseau multiplexé d'une grande simplicité et peu coûteux à mettre en oeuvre.

Bien que l'invention ait été décrite en liaison avec des modes de réalisation particuliers, elle comprend tous les équivalents techniques des moyens décrits.

**Revendications**

1. Procédé de localisation des courts-circuits dans au moins un bus (2, 3) d'un réseau (1) de transmission d'informations multiplexé, le réseau (1) comportant une pluralité de calculateurs ou stations (C1 à Cn; F1 à Fm) reliées à une unité centrale (4) via au moins un bus (2, 3), le ou les bus (2, 3) étant constitués d'au moins deux fils conducteurs caractérisé en ce qu'il comporte :

- deux étapes de mesure de la résistance ohmique du bus (2, 3) réalisée respectivement sensiblement au niveau des deux extrémités du bus (2, 3),
- une étape de calcul de la distance du court-circuit par rapport à une des extrémités du bus (2, 3) en fonction des valeurs connues de résistivité ($\rho$) et de résistance ($R_T$) totale du bus (2, 3),
- une étape de comparaison de la distance calculée du court-circuit par rapport à une des extrémités du bus (2, 3) avec les longueurs connues des bus (2, 3) ainsi que les emplacements relatifs connus des calculateurs ou stations (C1 à Cn; F1 à Fm) du réseau (1).

2. Procédé de localisation des courts-circuits dans au moins un bus (2, 3) d'un réseau (1) de transmission d'informations multiplexé selon la revendication 1 caractérisé en ce que chacune des étapes de mesure de la résistance ohmique du bus (2, 3) consiste à mesurer successivement les résistances d'une pluralité de boucles formées chacune par deux fils du bus (2, 3).

3. Procédé de localisation des courts-circuits dans au moins un bus (2, 3) d'un réseau (1) de transmission d'informations multiplexé selon la revendication 1 ou 2 caractérisé en ce que le bus (2, 3) est constitué de deux fils véhiculant l'information, chacune des étapes de mesure de la résistance ohmique du bus (2, 3) consistant à mesurer successivement les résistances des boucles formées par la paire de fils véhiculant l'information et chaque fil véhiculant l'information par rapport aux deux polarités de l'alimentation du véhicule.

4. Procédé de localisation des courts-circuits dans au moins un bus (2, 3) d'un réseau (1) de transmission d'informations multiplexé selon la revendication 1 à 3 caractérisé en ce que les étapes de mesure de la résistance ohmique du bus (2, 3) sont réalisées sur la ligne dite principale (a11, a12) du bus (2, 3) qui est connectée à l'unité centrale (4).

5. Procédé de localisation des courts-circuits dans au moins un bus (2, 3) d'un réseau (1) de transmission d'informations multiplexé selon l'une quelconque des revendications 1 à 4 caractérisé en ce que l'étape de calcul de la distance (D1) du court-circuit par rapport à une première des extrémités du bus (2, 3) est obtenue par la formule :

$$D1 = \frac{1}{2\rho} \times (R_{BG} - \frac{R_{BG}+R_{BD}-R_T}{2});$$

dans laquelle $R_{BG}$ est la résistance mesurée à la première extrémité du bus, $R_{BD}$ est la résistance mesurée à la seconde extrémité du bus et $R_T$ la résistance totale du bus.

6. Procédé de localisation des courts-circuits dans au moins un bus (2, 3) d'un réseau (1) de transmission d'informations multiplexé selon l'une quelconque des revendications 1 à 5 caractérisé en ce que l'une des deux étapes de mesure de la résistance ohmique du bus (2, 3) est réalisée au niveau de la connexion du bus (2, 3) à l'unité centrale (4), l'autre étape de mesure de résistance étant réalisée au niveau de la connexion du bus (2, 3) au calculateur le plus éloigné de l'unité centrale (4).

7. Procédé de localisation des courts-circuits dans au moins un bus (2, 3) d'un réseau (1) de transmission d'informations multiplexé selon les revendications 2 ou 3 caractérisé en ce que chacune des étapes de mesure de la résistance ohmique du bus (2, 3) comporte une pluralité de mesures de résistance successives pour chaque paire de fils.

8. Dispositif de diagnostic d'un réseau (1) électronique de transmission d'informations multiplexé de mise en oeuvre du procédé selon l'une quelconque des revendications précédentes, caractérisé en ce qu'il comporte des moyens de mesure de la résistance ohmique des fils constituant les bus (2, 3), des moyens de stockage et de traitement de données et des moyens d'affichage interactifs des informations relatives à la localisation du ou des courts-circuits dans le ou les bus (2, 3) du réseau (1).

9. Dispositif de diagnostic d'un réseau (1) électronique de transmission d'informations multiplexé selon la revendication 8 caractérisé en ce que les moyens de stockage et de traitement de données coopèrent avec les moyens d'affichage pour indiquer à l'utilisateur l'emplacement de l'une au moins des deux extrémités du bus (2, 3) auxquelles une mesure de résistance doit être effectuée.

10. Dispositif de diagnostic d'un réseau (1) électronique de transmission d'informations multiplexé selon la revendication 8 ou 9 caractérisé en ce que les moyens de mesure de la résistance ohmique des fils constituant les bus (2, 3) comportent des moyens (10) de génération d'un courant électrique reliés en parallèle à des moyens (11) de mesure d'une tension de façon à constituer deux bornes (12, 13) de mesure à connecter sur respectivement deux fils du bus.

FIG.1

FIG.2

FIG.6

7

FIG.3

FIG.4

101 — MESURE DE $R_{BG}$

102 — MESURE DE $R_{BD}$

103 — DETERMINATION DE LA DISTANCE DU COURT-CIRCUIT PAR RAPPORT A UNE EXTREMITE DU BUS

MODELISATION — 200

104 — COMPARAISON

105 — LOCALISATION DU COURT-CIRCUIT DANS LE RESEAU

106 — AFFICHAGE

## FIG.5

Office européen des brevets

# RAPPORT DE RECHERCHE EUROPEENNE

Numéro de la demande

EP 99 40 1392

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| Y | EP 0 474 907 A (FUJIKURA LTD) 18 mars 1992 (1992-03-18) * abrégé; figures 5,7 * * colonne 3, ligne 9 - ligne 11 * --- | 1-10 | G01R31/08 |
| A | HIROAKI KOGA ET AL: "STUDY OF FAULT-LOCATION EXPERT SYSTEMS FOR PAIRED CABLES" ELECTRONICS & COMMUNICATIONS IN JAPAN, PART I - COMMUNICATIONS, vol. 74, no. 10, 1 octobre 1991 (1991-10-01), pages 58-66, XP000303554 * page 59, colonne de gauche, alinéa 1 - alinéa 3; figure 2 * --- | 1 | |
| A | EP 0 784 209 A (HARNESS SYST TECH RES LTD ;SUMITOMO WIRING SYSTEMS (JP); SUMITOMO) 16 juillet 1997 (1997-07-16) * abrégé; figure 1 * --- | 1,8 | |
| A | EP 0 716 311 A (CHRYSLER CORP) 12 juin 1996 (1996-06-12) * abrégé; figure 1 * --- | 1,8 | DOMAINES TECHNIQUES RECHERCHES (Int.Cl.6) G01R H04L |
| Y | EP 0 327 191 A (AUTOMATED LIGHT TECHNOLOGIES) 9 août 1989 (1989-08-09) * abrégé; figures 1-3,5 * * page 5, ligne 33 - ligne 35 * * page 5, ligne 43 - ligne 46 * * page 6, ligne 11 - ligne 13 * --- | 1-10 | |
| A | EP 0 819 947 A (NORSCAN INSTR LTD) 21 janvier 1998 (1998-01-21) * abrégé; figures * --- | 1,8 | |

-/--

Le présent rapport a été établi pour toutes les revendications

| Lieu de la recherche | Date d'achèvement de la recherche | Examinateur |
|---|---|---|
| BERLIN | 7 septembre 1999 | Fritz, S |

EPO FORM 1503 03.82 (P04C02)

**Office européen des brevets**

**RAPPORT DE RECHERCHE EUROPEENNE**

Numéro de la demande

EP 99 40 1392

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| A | US 4 868 507 A (REED ERIC L)<br>19 septembre 1989 (1989-09-19)<br>* abrégé; figures 1,6 *<br>--- | 1,8 | |
| A | EP 0 681 187 A (FLUKE CORP)<br>8 novembre 1995 (1995-11-08)<br>* abrégé; figures *<br>* colonne 4, ligne 23 - ligne 29 *<br>--- | 1,8 | |
| A | EP 0 827 872 A (FORD MOTOR CO)<br>11 mars 1998 (1998-03-11)<br>* abrégé; figure 1 *<br>* colonne 1, ligne 3 - ligne 12 *<br>----- | 1,8 | |

DOMAINES TECHNIQUES
RECHERCHES (Int.Cl.6)

Le présent rapport a été établi pour toutes les revendications

| Lieu de la recherche | Date d'achèvement de la recherche | Examinateur |
|---|---|---|
| BERLIN | 7 septembre 1999 | Fritz, S |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 99 40 1392

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

07-09-1999

| Document brevet cité au rapport de recherche | | Date de publication | Membre(s) de la famille de brevet(s) | | Date de publication |
|---|---|---|---|---|---|
| EP 0474907 | A | 18-03-1992 | CA | 2025173 A,C | 13-03-1992 |
| | | | JP | 2250536 A | 08-10-1990 |
| EP 0784209 | A | 16-07-1997 | JP | 9189739 A | 22-07-1997 |
| | | | US | 5903156 A | 11-05-1999 |
| EP 0716311 | A | 12-06-1996 | US | 5530360 A | 25-06-1996 |
| | | | CA | 2164758 A | 10-06-1996 |
| | | | JP | 9026381 A | 28-01-1997 |
| EP 0327191 | A | 09-08-1989 | AT | 122468 T | 15-05-1995 |
| | | | CA | 1283704 A | 30-04-1991 |
| | | | DE | 68922503 D | 14-06-1995 |
| | | | US | 4947469 A | 07-08-1990 |
| EP 0819947 | A | 21-01-1998 | CA | 2179249 A | 18-12-1997 |
| US 4868507 | A | 19-09-1989 | AU | 613538 B | 01-08-1991 |
| | | | AU | 4469389 A | 31-05-1990 |
| | | | CA | 2002263 A,C | 23-05-1990 |
| | | | DE | 68907023 T | 04-11-1993 |
| | | | EP | 0370647 A | 30-05-1990 |
| | | | JP | 2184775 A | 19-07-1990 |
| | | | JP | 2796380 B | 10-09-1998 |
| | | | KR | 139078 B | 15-06-1998 |
| EP 0681187 | A | 08-11-1995 | US | 5559427 A | 24-09-1996 |
| | | | CA | 2137191 A,C | 05-10-1995 |
| | | | JP | 7301654 A | 14-11-1995 |
| | | | US | 5629628 A | 13-05-1997 |
| EP 0827872 | A | 11-03-1998 | US | 5701410 A | 23-12-1997 |
| | | | JP | 10107824 A | 24-04-1998 |

EPO FORM P0460

Pour tout renseignement concernant cette annexe : voir Journal Officiel de l'Office européen des brevets, No.12/82